# EUROPÄISCHE PATENTSCHRIFT

(11) **EP 1 631 990 B1**
(45) Veröffentlichungstag und Bekanntmachung des Hinweises auf die Patenterteilung: **27.06.2012**
(21) Anmeldenummer: 04741572.4
(22) Anmeldetag: 13.05.2004
(51) Int. Cl.: H01L 21/336, H01L 29/78

(54) **HERSTELLUNGSVERFAHREN FÜR EINEN FELDEFFEKTTRANSISTOR**
METHOD OF MANUFACTURING A FIELD EFFECT TRANSISTOR
PROCEDE DE FABRICATION D'UN TRANSISTOR A EFFET DE CHAMP

(30) Priorität: 12.06.2003 DE 10326523
(43) Veröffentlichungstag der Anmeldung: 08.03.2006
(73) Patentinhaber: Infineon Technologies AG, 85579 Neubiberg (DE)
(72) Erfinder: MÜLLER, Karlheinz, 84149 Velden (DE); RÖSCHLAU, Klaus, 85567 Grafing (DE)
(74) Vertreter: Kindermann, Peter
(86) Internationale Anmeldenummer: PCT/EP2004/050802
(87) Internationale Veröffentlichungsnummer: WO 2004/112101

(56) Entgegenhaltungen:
- US-A- 5 349 224
- US-A- 5 701 026
- US-A- 5 723 891
- US-A1- 2002 125 527
- PATENT ABSTRACTS OF JAPAN Bd. 018, Nr. 372 (E-1577), 13. Juli 1994 (1994-07-13) -& JP 06 104446 A (TOSHIBA CORP), 15. April 1994 (1994-04-15)

## Beschreibung

Die Erfindung betrifft ein Verfahren zur Herstellung eines Feldeffekttransistors, der unter anderem die folgenden Elemente enthält:
- einen Driftbereich,
- einen an den Driftbereich angrenzenden Graben, der einen Grabenrand, Seitenwände und einen Grabenboden enthält,
- einen in dem Graben angeordneten Steuerbereich des Feldeffekttransistors, der auch als Gate bezeichnet wird,
- zwei Anschlussbereiche des Feldeffekttransistors, die auch als Source und Drain bezeichnet werden und durch die ein Strom fließt, der auch durch einen Inversionskanal und den Driftbereich fließt, und
- einen vom Steuerbereich durch ein Dielektrikum getrennten Body-Bereich für die Ausbildung des Inversionskanals des Feldeffekttransistors.

Die Erfindung betrifft ein Verfahren zur Herstellung von MOS-Transistoren mit Driftstrecken bzw. DMOS-Transistoren (Double Diffused Metaloxide Semiconductor), bei denen Anschlüsse für den Steuerbereich und für die Anschlussbereiche in einer Ebene liegen, so dass eine Integration in eine integrierte Schaltungsanordnung möglich ist. Bei DMOS-Transistoren wird bspw. sowohl der eine Anschlussbereich als auch der Body-Bereich durch Diffusion erzeugt. Der Drainbereich grenzt an den Driftbereich an. Der Sourcebereich grenzt and den Bodybereich an.

Aus der US 5,701,026, Figur 9, ist ein Graben MISFET bekannt, wobei der Graben eine Drainelektrode aus WSi enthält und einen polykristallinen Steuerbereich bzw. Gatebereich.

Aus der US 5,349,224 sind MOS- und IGBT-Anordnungen mit Grabenstruktur bekannt. Ein Graben enthält einen polykristallinen Steuerbereich. An der Stelle eines ehemaligen Grabengebietes, wurde der Graben wieder entfernt, wobei wieder ein Substratgebiet erzeugt wurde für einen monokristallinen Driftbereich und einen monokristallinen Anschlussbereich.

Die US 5,723,891 betrifft einen RESURF-DMOS-Transistor mit Graben und oberflächennahem Drain. Der Transistor enthält in einem Querschnitt zwei Gräben, in denen jeweils ein Teil des Steuerbereiches angeordnet ist. Zwischen den Gräben ist das Drain in monokristallinem Silizium angeordnet.

Die US 2002/0125527 A1 betrifft einen Graben-DMOS-Transistor, bei dem Steuerbereich und Anschlussbereich in verschiedenen Gräben angeordnet sind. Aus der JP 06104446 ist ein vertikaler doppelt diffundierter MOSFET bekannt, bei dem ein Steuerbereich in einem Graben angeordnet ist. Drainbereiche sind in monokristallinem Silizium angeordnet. Aus der JP 02249276, Figur 2, ist ein vertikaler DMOS bekannt, der durch Rillen isoliert ist, die mit einem Isolator gefüllt sind. Ein Steuerbereich des Transistors ist ebenfalls in einer Rille angeordnet.

Es ist Aufgabe der Erfindung ein einfaches Herstellungsverfahren für einen kompakten Feldeffekttransistor anzugeben.

Bei dem nach dem erfindungsgemäßen Verfahren hergestellten Feldeffekttransistor sind zusätzlich zu den eingangs genannten Merkmalen die folgenden Merkmale vorhanden:
- der eine Anschlussbereich ist außerhalb des Grabens angeordnet, vorzugsweise angrenzend an den Bereich für die Ausbildung des Inversionskanals des Feldeffekttransistors, und
- der andere Anschlussbereich oder ein Teil des anderen Anschlussbereiches ist in dem Graben angeordnet, in dem sich auch der Steuerbereich des Feldeffekttransistors befindet, wobei der andere Anschlussbereich der Anschlussbereich ist, der an den Driftbereich angrenzt.

Das bedeutet, dass bei dem nach dem erfindungsgemäßen Verfahren hergestellten Feldeffekttransistor sowohl der Steuerbereich als auch einer der Anschlussbereiche in demselben Graben angeordnet sind. Durch diese Anordnung lässt sich die effektiv benötigte Chipfläche reduzieren. Insbesondere dann, wenn der Graben ohnehin zur Isolation erforderlich gewesen wäre. Über die Tiefe des Grabens lässt sich außerdem die Länge der Driftstrecke einstellen, beispielsweise für Drain-Source-Spannungen kleiner als 30 Volt oder kleiner als 40 Volt oder für Drain-Source-Spannungen größer als 30 oder größer als 40 Volt und insbesondere kleiner als 100 Volt.

Durch die erfindungsgemäße Verfahren wird außerdem ein Feldeffekttransistor mit einem kleinen spezifischen Einschaltwiderstand RON mal Fläche und einem hohen Sättigungsstrom ISAT pro Fläche erzielt. Durch die Anordnung von Steuerbereich und Anschlussbereich in einem Graben sind außerdem nur wenige Verfahrensschritte für die Herstellung erforderlich. Außerdem entstehen Freiheitsgrade für die Realisierung unterschiedlicher elektronischer Eigenschaften des Feldeffekttransistors.

Bei einer Weiterbildung des nach dem erfindungsgemäßen Verfahren hergestellten Feldeffekttransistors ist zwischen dem Grabenboden unter dem Steuerbereich * und dem Steuerbereich Isoliermaterial angeordnet. Die Grenze zwischen dem Steuerbereich und dem Isoliermaterial liegt in der oberen Hälfte des den Steuerbereich enthaltenden Grabenteils oder im oberen Drittel des den Steuerbereich enthaltenden Grabenteils. Die Grenze zwischen den beiden Bereichen liegt bei einer Ausgestaltung parallel zum tiefen Grabenboden. Der Bereich mit dem Isoliermaterial dient zum Einstellen der Länge der Driftstrecke. So erstreckt sich der Steuerbereich beispielsweise nur bis in eine Tiefe von 500 nm. Die tiefsten Stellen im Graben, die mit Isoliermaterial gefüllt sind, erstrecken sich jedoch auch in eine Tiefe von beispielsweise größer als 1 µm oder sogar in eine Tiefe bis zu 8 µm. Durch die langen Isolierbereiche wird eine hohe Spannungsfestigkeit erreicht, ohne dass zusätzliche Chipfläche erforderlich ist. Der Isolierbereich lässt sich aber auch mit allseitig elektrisch isoliertem elektrisch leitfähigem Material füllen.

Bei einer anderen Weiterbildung erstreckt sich der Graben unter dem Steuerbereich tiefer als unter dem innenliegenden Anschlussbereich. Bei einer Ausgestaltung ist der Graben unter dem Steuerbereich mehr als doppelt so tief oder mehr als dreimal so tief wie unter dem innenliegenden Anschlussbereich. Durch diese Maßnahme liegt das Driftgebiet auf beiden Seiten des tiefgehenden Isoliermaterials, so dass die Länge des Driftgebietes bei gleicher Grabentiefe etwa verdoppelt wird.

Bei einer alternativen Weiterbildung ist der Graben unter dem innenliegenden Anschlussbereich tiefer als unter dem Steuerbereich. Dies ist beispielsweise dann der Fall, wenn der Graben ein flacher Graben ist, d.h. ein Graben mit einer Tiefe kleiner als 1 µm, insbesondere mit einer Tiefe kleiner als 500 nm. In diesem Fall muss der innenliegende Anschlussbereich den Grabenboden des flachen Grabens durchdringen, um den Driftbereich sicher zu kontaktieren.

Bei einer nächsten Weiterbildung ist der Graben frei von monokristallinem Halbleitermaterial. Der Graben lässt sich auf einfache Art und Weise mit polykristallinem Halbmaterial und mit einem elektrisch isolierenden Material füllen.

Der Steuerbereich wird gemäß dem ersten Dotiertyp dotiert, vorzugsweise n-dotiert. Bei einer Ausgestaltung sind die Anschlussbereiche ebenfalls mit dem ersten Dotiertyp dotiert, d.h. n-dotiert. Die Anschlussbereiche sind vorzugsweise sehr hoch dotiert, beispielsweise mit 10¹⁹ oder 10²⁰ Dotieratomen je Kubikzentimeter.

Der Bereich für die Ausbildung des Inversionskanals ist vorzugsweise p-dotiert. Das Driftgebiet ist vorzugsweise gemäß dem ersten Dotiertyp dotiert, insbesondere n-dotiert. Die Dotierung des Driftgebietes ist vergleichsweise gering, damit große Spannungsabfälle erzeugt werden. Beispielsweise beträgt die Dotierung des Driftgebietes 10¹⁵ Dotieratome je Kubikzentimeter.

Bei einer anderen Ausgestaltung ist das innenliegende Anschlussgebiet im Vergleich zum Driftgebiet stärker dotiert. Bei einer anderen Ausgestaltung sind der außenliegende Anschlussbereiche, der Driftbereich und der Bereich für den Anschluss des Inversionskanals in monokristallinem Halbmaterial angeordnet, vorzugsweise in monokristallinem Silizium.

Bei einer nächsten Weiterbildung ist der Feldeffekttransistor in einer integrierten Schaltung integriert, in der sich weitere Bauelemente befinden, die untereinander mit Leitbahnen verbunden sind, beispielsweise Bauelemente einer Steuerschaltung zum Ansteuern des Feldeffekttransistors. Jedoch lässt sich der Feldeffekttransistor oder eine seiner Weiterbildungen auch als separates Bauelement aufbauen.

Bei einer Weiterbildung enthält der Feldeffekttransistor eine im Vergleich zum Driftgebiet stark dotierte Schicht, die den Feldeffekttransistor von einem Substrat isoliert, wobei das Substrat gemäß einem anderen Dotiertyp dotiert ist als die stark dotierte Schicht. Diese Weiterbildung wird sowohl in Schaltungen mit Bipolartransistoren und Feldeffekttransistoren, z.B. in BiCMOS-Schaltungen, als auch dann eingesetzt, wenn der Feldeffekttransistor in einer integrierten Schaltung hergestellt wird, in der sich nur Feldeffekttransistoren und abgesehen von parasitären Transistoren keine Bipolartransistoren befinden.

Bei einer nächsten Weiterbildung erstreckt sich der Graben bis in die stark dotierte Schicht hinein, so dass die stark dotierte Schicht auch als Anschlussgebiet für das Driftgebiet genutzt wird. Bei einer alternativen Weiterbildung ist der Graben mit Abstand zu der stark dotierten Schicht angeordnet. Durch diese Maßnahme lässt sich auch ein Bereich zwischen dem Graben und der stark dotierten Schicht als Driftstrecke benutzen.

Bei einer nächsten Weiterbildung hat der Graben zwei Grabenenden, wobei vorzugsweise in dem Graben ein weiterer Steuerbereich angeordnet ist. Der Graben verläuft bei dieser Weiterbildung vorzugsweise geradlinig. Diese Weiterbildung ist insbesondere für bestimmte Metallisierungen geeignet, die aufgrund von Elektromigrationvorgängen nur bestimmte Stromdichten führen können.

Bei einer alternativen Weiterbildung bildet der Graben einen Ring, wobei vorzugsweise ein ringförmiger Steuerbereich den inneren Anschlussbereich umgibt. Durch den ringförmigen Graben lassen sich Feldeffekttransistoren auf einer geringen Chipfläche herstellen.

Die Erfindung betrifft ein Verfahren zum Herstellen eines Feldeffekttransistors, so dass die oben genannten technischen Wirkungen für das Verfahren gelten. Bei dem Verfahren werden ohne Beschränkung durch die angegebene Reihenfolge die Verfahrensschritte entsprechend Anspruch 1 ausgeführt.

Bei einer Weiterbildung wird der Graben in mindestens einem Teilbereich unter Beibehaltung der Grabentiefe in mindestens einem anderen Teilbereich vertieft, wobei Grabenbereiche mit voneinander verschiedener Grabentiefe entstehen. Diese Weiterbildung lässt sich insbesondere dann ohne zusätzliche Prozessschritte ausführen, wenn in der integrierten Schaltungsanordnung, die den Feldeffekttransistor enthält, ohnehin tiefe Isoliergräben und flache Isoliergräben vorhanden sein müssen.

Bei einer Weiterbildung des Verfahrens werden die Aussparungen bis zum Grabenboden geätzt, wobei das Isoliermaterial in einem Grabenwandbereich der Aussparung für den Steuerbereich entfernt wird. Anschließend wird mit Hilfe einer thermischen Oxidation ein qualitativ hochwertiges Oxid, d.h. das Gateoxid, an dem freiliegenden Grabenwandbereich in der Aussparung für den Steuerbereich erzeugt. Dieses Oxid wird danach in der Aussparung für den Anschlussbereich wieder entfernt, bevor das elektrisch leitende Material eingebracht wird.

Bei einer alternativen Verfahrensführung werden die Aussparungen nicht bis zum Grabenboden erzeugt, sondern der Boden der Aussparungen hat einen Abstand zum Grabenboden, der größer als bspw. 100 Nanometer ist. Jedoch wird das Isoliermaterial in einem Grabenwandbereich der Aussparung für den Steuerbereich entfernt. Anschließend wird mit Hilfe einer thermischen Oxidation das qualitativ hochwertige Dielektrikum in der Aussparung für den Steuerbereich erzeugt. Danach wird die Aussparung für den Anschlussbereich bis zum Grabenboden vertieft.

Bei einer nächsten Weiterbildung des Verfahrens wird außerhalb des Grabens ein Anschlussbereich angrenzend zum Grabenrand erzeugt, vorzugsweise ein Anschlussbereich mit einer extra implantierten Erweiterung, die beispielsweise geringer dotiert ist als der Anschlussbereich.

Im Folgenden werden Ausführungsbeispiele der Erfindung an Hand der beiliegenden Zeichnungen erläutert. Darin zeigen:
- Figur 1: einen DMOS-Transistor mit flachem Isoliergraben,
- Figur 2: einen DMOS-Transistor mit einem tiefen Isoliergraben,
- Figur 3: einen DMOS-Transistor mit einem Isoliergraben unterschiedlicher Grabentiefe,
- Figur 4: ringförmige DMOS-Transistoren, und
- Figur 5: einen streifenförmigen DMOS-Transistor.

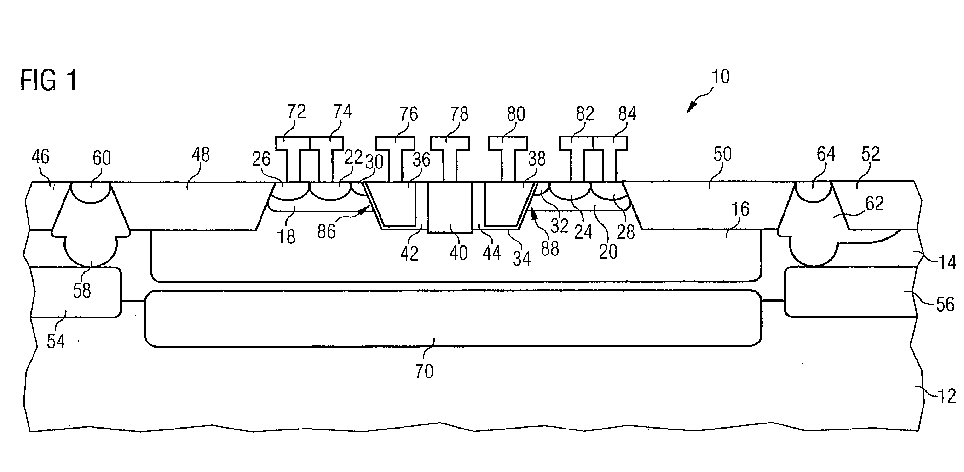

Figur 1 zeigt einen DMOS-Transistor 10, der Bestandteil eines integrierten Schaltkreises ist. Der integrierte Schaltkreis ist auf einem Substrat 12 aufgebaut, das beispielsweise aus leicht p-dotiertem Silizium besteht. Auf der Substratoberfläche des Substrats 12 befindet sich eine n-dotierte Epitaxieschicht 14, die beispielsweise eine Dicke größer 1,5 µm oder größer 2,0 µm hat.

In der n-Epitaxieschicht 14 sind mit zunehmendem Abstand vom Substrat 12 ausgebildet:
- eine n-dotierte Wanne 16,
- p-dotierte Kanalausbildungsgebiete 18, 20, und
- an der Oberfläche der Epitaxieschicht 14 stark n-dotierte Sourceanschlussbereiche 22, 24, stark p-dotierte Anschlussbereiche 26, 28 für das Kanalanschlussgebiet 18 bzw. 20 sowie gering n-dotierte Verlängerungsbereiche 30, 32 des Sourceanschlussbereiches 22 bzw. 24. Die Verlängerungsbereiche 30, 32 sind optional und werden bei einem anderen Ausführungsbeispiel weggelassen.

Der Transistor 10 enthält in seinem zentralen Teil einen flachen Graben 34, in dem zwei stark n-dotierte Gatebereiche 36, 38 in Randbereichen und ein stark n-dotierter Drainbereich 40 im zentralen Teil angeordnet sind. Der Drainbereich 40 ist vom Gatebereich 36 durch einen Isolationsbereich 42 und vom Gatebereich 38 durch einen Isolationsbereich 44 getrennt. Die Isolationsbereiche 42 und 44 befinden sich ebenfalls im Graben 34. An den Grabenwänden und am Grabenboden unterhalb der Gatebereiche 36 und 38 des Grabens 34 befindet sich eine dünne Isolationsschicht, welche die Gatebereiche 36, 38 von der n-Wanne 16 bzw. vom Kanalausbildungsgebiet 18, 20 und von den Verlängerungsbereichen 30 bzw. 32 isoliert. Als Isoliermaterial ist beispielsweise Siliziumdioxid oder ein anderes Material geeignet.

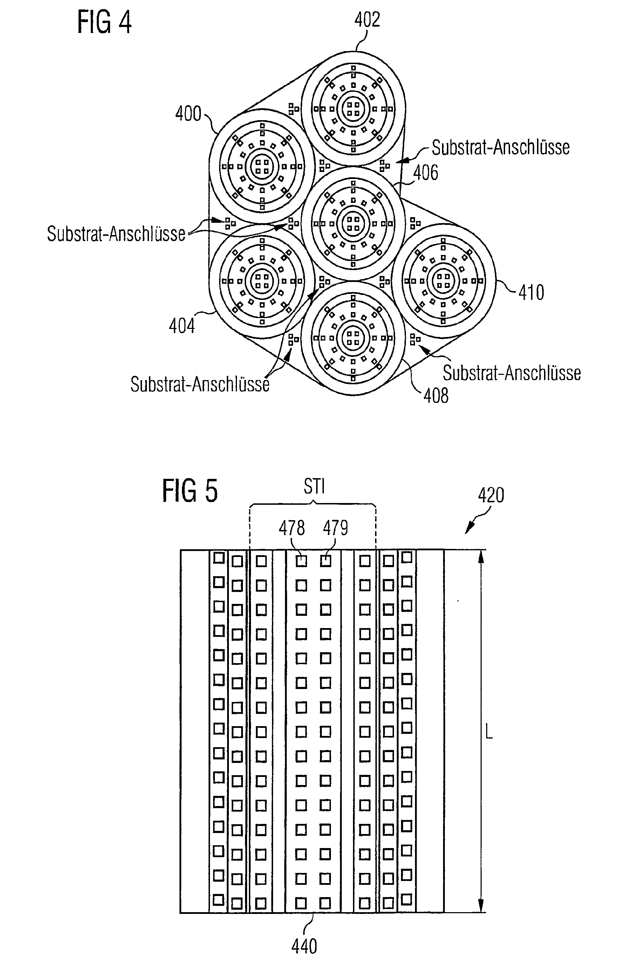

Gemeinsam mit dem Graben 34 wurden weitere Isolationsgräben 46 bis 52 ausgebildet, die alle die gleiche Tiefe haben, von beispielsweise 0,5 µm. Der Transistor 10 wird durch die beiden angrenzenden Isolationsgräben 48 bzw. 50 sowie weiter unten erläuterte Isolierwannen von anderen Bauelementen der integrierten Schaltungsanordnung elektrisch isoliert. Die beiden Isolationsgräben 48 und 50 sind bei einem Ausführungsbeispiel auch Bereiche eines ringförmigen Isolationsgrabens, siehe Erläuterungen zur Figur 4.

Bei dem an Hand der Figur 1 erläuterten Ausführungsbeispiel, das zum Verständnis beanspruchten Verfahrens dient, befinden sich der Body-Anschlussbereich 26, der Sourceanschlussbereich 22 und der Verlängerungsbereich 30 zwischen dem Isoliergraben 48 und dem Graben 34. Der Verlängerungsbereich 32, der Sourceanschlussbereich 24 und der Body-Anschlussbereich 28 befinden sich zwischen den Isolationsgräben 34 und 50.

Die integrierte Schaltungsanordnung trägt neben dem auf den gemäß Feldeffekt arbeitenden Transistoren 10 auch npn- bzw. pnp-Bipolartransistoren, beispielsweise rechts und links des Feldeffekttransistors 10. Links des Transistors 10 befindet sich in Bereichen des Substrats 12 und den Bereichen der Epitaxieschicht 14 eine p-dotierte vergrabene Schicht 54, die zur Isolation von Bipolartransistoren dient. Auf der rechten Seite des Transistors 10 befindet sich in gleicher Höhe wie die vergrabene Schicht 54 eine vergrabene Schicht 56, die ebenfalls der Isolation von Bipolartransistoren dient. Die vergrabene Schicht 54 ist über einen p-dotierten Anschlussbereich 58 und einen stark p-dotierten Anschlussbereich 60 an der Oberfläche der Epitaxieschicht 14 angeschlossen. Die vergrabene Schicht 56 ist über einen p-dotierten Anschlussbereich 62 und über einen stark p-dotierten Anschlussbereich 64 an der Oberfläche der Epitaxieschicht 14 angeschlossen. Der Anschlussbereich 60 liegt zwischen den Isolationsgräben 46 und 48. Der Anschlussbereich 64 liegt dagegen zwischen den Isolationsgräben 50 und 52.

Unterhalb des Feldeffekttransistors 10 befindet sich eine stark n-dotierte vergrabene Schicht 70, die sich zu einem geringen Teil in der Epitaxieschicht 14 und zum Großteil im p-Substrat 12 befindet. Die vergrabene Schicht 70 dient zur Isolation des Transistors 10 gegen das Substrat 12. Bei einem anderen Ausführungsbeispiel ist die vergrabene Schicht 70 nicht vorhanden.

Der Transistor 10 lässt sich ohne Epitaxieschicht 14 realisieren, z.B. in einem Prozess bei dem ausschließlich CMOS-Transistoren gefertigt werden sollen. Die n-Wanne 16 erstreckt sich dann in einem p-Substrat 12 oder in einer p-Wanne im n-Substrat.

In Figur 1 sind außerdem metallische Anschlüsse dargestellt, nämlich:
- ein linker Bodyanschluss 72, der zum Body-Anschlussbereich 26 führt,
- ein linker Sourceanschluss 74, der zum Sourcebereich 22 führt,
- ein linker Gateanschluss 76, der zum Gatebereich 36 führt,
- ein Drainanschluss 78, der mit dem Drainbereich 40 elektrisch leitfähig verbunden ist,
- ein rechter Gateanschluss 80, der mit dem Gatebereich 38 verbunden ist,
- ein rechter Sourceanschluss 82, der mit dem Sourcebereich 24 verbunden ist, und
- ein rechter Bodyanschluss 74, der mit dem Anschlussbereich 28 verbunden ist.

Wie in Figur 1 dargestellt, sind der linke Bodyanschluss 72 und der linke Sourceanschluss 74 miteinander leitfähig verbunden. Außerdem sind der rechte Sourceanschluss 82 und der rechte Bodyanschluss 84 miteinander leitfähig verbunden. Üblicherweise wird auch der linke Sourceanschluss 74 mit dem rechten Sourceanschluss 82 elektrisch leitfähig verbunden. Ebenso werden der linke Gateanschluss 76 und der rechte Gateanschluss 80 miteinander elektrisch leitfähig verbunden. Die beiden Gateanschlüsse werden bei einem anderen Ausführungsbeispiel getrennt voneinander angesteuert und sind damit nicht verbunden. Gleiches lässt sich für die beiden Sourceanschlüsse realisieren.

Der Drainbereich 40 durchdringt den Graben 34 und endet in der n-Wanne 16, so dass sich beim Betrieb des Transistors 10 eine Driftstrecke vom unteren Boden des Drainbereiches 40 aus in Richtung zu einem linken Kanalbereich 86 und eine weitere Driftstrecke vom Boden des Drainbereiches 40 aus in Richtung zu einem rechten Kanalbereich 88 hin ausbildet. Die Ausbildung des Kanalbereiches wird durch die an den Gatebereichen 76 bzw. 80 anliegende Spannung gesteuert.

Bei einem anderen Ausführungsbeispiel, das zum Verständnis des beanspruchten Verfahrens dient, gibt es keine elektrisch leitfähige Verbindung zwischen den Bodyanschlüssen 72, 84 und den Sourceanschlüssen 74, 82, wenn das Entstehen von parasitären npn-Transistoren durch andere Maßnahmen verhindert wird. Die Dotierung der n-Wanne 16 hängt von der geforderten Spannungsfestigkeit für den Transistor 10 ab.

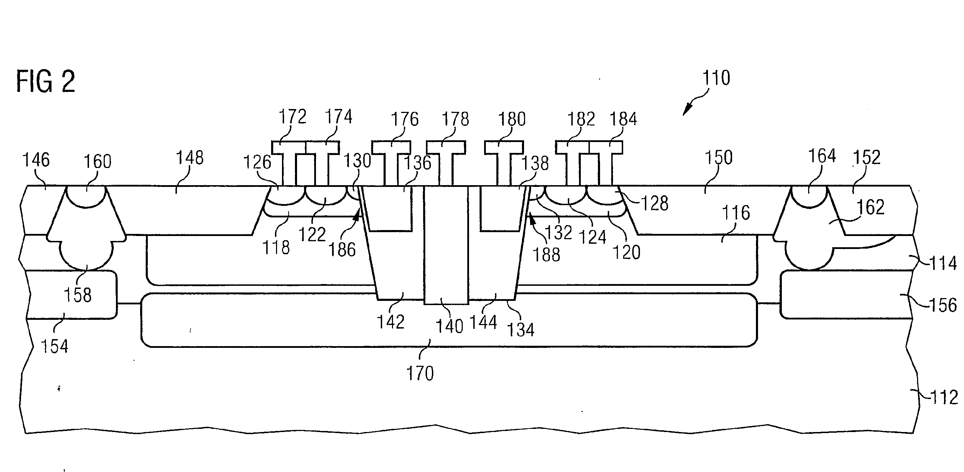

Figur 2 zeigt einen DMOS-Feldeffekttransistor 110, der bis auf die im folgenden erläuterten Unterschiede wie der Feldeffekttransistor 10 aufgebaut und hergestellt worden ist, so dass Elemente, die bereits oben an Hand der Figur 1 erläutert worden sind, nicht noch einmal erläutert werden. Diese Elemente haben in Figur 2 das gleiche Bezugszeichen, jedoch mit einer vorangestellten 1. So entspricht der n-Wanne 16 des Transistors 10 eine n-Wanne 116 des Transistors 110.

Beim Transistor 110 erstreckt sich der Graben 134 in die vergrabene Schicht 170 hinein. Der Graben 134 ist bei dem an Hand der Figur 2 dargestellten Ausführungsbeispiel ein tiefer Isolationsgraben mit einer Tiefe größer als 1 Mikrometer, z.B. mit einer Tiefe von 1,2 Mikrometern. Bei einem anderen Ausführungsbeispiel ist der Graben 134 dagegen ein flacher Isolationsgraben.

Die Gatebereiche 136 und 138 erstrecken sich nur im oberen Teil des Grabens 134, beispielsweise bis in eine Tiefe von 0,5 Mikrometer ausgehend von der Oberfläche der n-Epitaxieschicht 114. Der Bereich unterhalb des Gatebereiches 136 bis zum Grabenboden wird vom Isoliermaterial des Isolierbereiches 142 gefüllt, der auch weiterhin den Gatebereiche 136 vom Drainbereich 140 isoliert. Der Bereich unterhalb des Gatebereiches 138 bis zum Grabenboden wird auf gleiche Weise vom Isoliermaterial des Isolierbereiches 144 gefüllt, der auch weiterhin den Gatebereich 138 vom Drainbereich 140 isoliert. Der Drainbereich 140 durchdringt den Grabenboden des Grabens 134 und endet in der vergrabenen Schicht 170.

Bei dem in Figur 2 dargestellten Transistor 110 ist die Driftstrecke in der n-Wanne 116 aufgrund der größeren Tiefe des Grabens 134 im Vergleich zur Tiefe des Grabens 34 verlängert obwohl sie keinen unter dem Grabenboden liegenden Teil hat, so dass höhere Drain-Source-Spannungen anliegen können.

Bei der Variante gemäß Figur 2 fließt der Driftstrom außerdem entlang eines linearen Weges, so dass keine Feldspitzen an Krümmungen auftreten können, wie es noch bei der Variante gemäß Figur 1 der Fall ist, siehe Krümmung an der unteren Grabenkante des Grabens 34.

Der Transistor 110 wird bei einem weiteren Ausführungsbeispiel, das zum Verständnis des beanspruchten Verfahrens dient, ohne Epitaxieschicht ausgebildet, so dass sich die n-Wanne 116 im Substrat 112 erstreckt. Bei einem nächsten Ausführungsbeispiel, das zum Verständnis des beanspruchten Verfahrens dient, mit oder ohne Epitaxieschicht 114 fehlt die vergrabene Schicht 170.

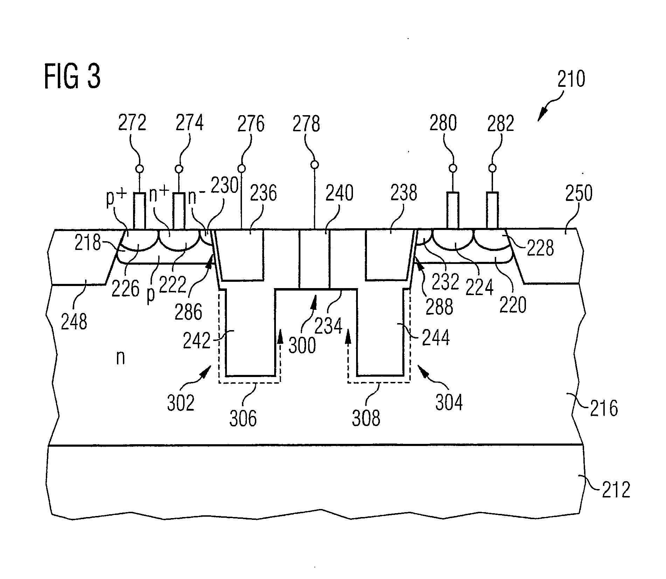

Figur 3 zeigt einen DMOS-Feldeffekttransistor 210, der bis auf die im folgenden erläuterten Unterschiede wie der Feldeffekttransistor 10 aufgebaut und hergestellt worden ist, so dass Elemente, die bereits oben an Hand der Figur 1 erläutert worden sind, nicht noch einmal erläutert werden. Diese Elemente habe in Figur 3 das gleiche Bezugszeichen, jedoch mit einer vorangestellten 2. So entspricht der n-Wanne 16 des Transistors 10 eine n-Wanne 216 des Transistors 210.

Im Gegensatz zum Transistor 10 fehlen beim Transistor 210:
- die Epitaxieschicht 14, so dass sich die n-Wanne 216 in einem Substrat 212 befindet,
- die vergrabenen Schichten 54 und 56 sowie die Anschlussbereiche zum Anschluss dieser Schichten.

Der zentrale Graben 234 des Transistors 210 hat einen mittleren flachen Grabenbereich 300 und zwei äußere tiefe Grabenbereiche 302 und 304 unterhalb der Gatebereiche 236 und 238. Die tiefen Grabenbereiche 242 und 244 sind elektrisch isolierend und nehmen die unteren Teilen der Isolierbereiche 242 und 244 auf. Die tiefen Grabenbereiche 242 und 244 erstrecken sich beispielsweise bis in eine Tiefe von 6 µm (Mikrometer) oder sogar bis in eine Tiefe von 20 µm. Der Drainanschlussbereich 240 befindet sich im flachen Grabenteil des Grabens 234 und endet tiefer als der flache Grabenbereich 300 in der n-Wanne 216, beispielsweise um mehr als 100 nm oder um mehr als 200 nm tiefer, z.B. um 500 nm tiefer. Aufgrund der tiefen Grabenbereiche 302 und 304 werden die Längen von Driftstrecken 306 und 308 etwa doppelt so lang wie die Tiefe der tiefen Grabenbereiche. Bei tiefen Grabenbereichen mit einer Tiefe von 5 µm sind die Driftstrecken 306 bzw. 308 beispielsweise über 10 µm lang. Diese langen Driftstrecken lassen sich erzielen, ohne dass zusätzliche Chipfläche in lateraler Richtung benötigt wird.

Auch der Transistor 210 lässt sich mit stark n-dotierter vergrabener Isolierschicht ausführen. Bei einem weiteren Ausführungsbeispiel, das zum Verständnis des beanspruchten Verfahrens dient, reichen die tiefen Grabenbereiche 302 und 304 jedoch nicht bis zu der Isolierschicht. Auch die Verwendung einer Epitaxieschicht ist möglich.

Figur 4 zeigt ringförmige DMOS-Transistoren 400 bis 410, die bei einem ersten Ausführungsbeispiel, das zum Verständnis des beanspruchten Verfahrens dient, alle wie der Transistor 10 aufgebaut sind. Bei anderen Ausführungsbeispielen, das zum Verständnis des beanspruchten Verfahrens dient, sind die Transistoren 400 bis 410 alle wie der Transistor 110 bzw. wie der Transistor 210 aufgebaut. Die Transistoren 400 bis 410 sind parallel geschaltet, so dass beispielsweise Ströme bis zu 3 A (Ampere) geschaltet werden können, wenn 50 oder 100 Transistoren 400 bis 410 parallel geschaltet werden. Solche Ströme werden beispielsweise bei Steuerschaltungen für die Ansteuerung von Festplatten in Computern benötigt. Die benötigte Fläche für die in Figur 4 dargestellte Anordnung ist sehr klein.

Figur 5 zeigt einen streifenförmigen DMOS-Transistor 420, der bei einem ersten Ausführungsbeispiel, das zum Verständnis des beanspruchten Verfahrens dient, wie der Transistor 10 aufgebaut ist, wobei es jedoch zwei Reihen von Drainanschlüssen 478, 479 oberhalb des Drainbereiches 440 gibt. Eine Länge L des Transistors 420 ist frei wählbar abhängig von dem zu schaltenden Strom. Außerdem lassen sich wieder mehrere streifenförmige Transistoren 420 parallel zueinander schalten. Die streifenförmigen Transistoren 420 sind insbesondere dann geeignet, wenn die Metallisierung der Drainanschlüsse 478, 479 nur einen begrenzten Stromfluss zulässt.

Bei einem anderen Ausführungsbeispiel, das zum Verständnis des beanspruchten Verfahrens dient, sind die an Hand der Figur 4 erläuterten Varianten mit sechseckigen, d.h. mit wabenförmigen Transistoren ausgeführt.

Im Folgenden werden Herstellungsschritte zum Herstellen des Transistors 10 erläutert. Dabei werden die folgenden Verfahrensschritte nacheinander ausgeführt:
- in einer auf dem Substrat 12 aufgewachsenen Epitaxieschicht 14 wird die n-Wanne 16 erzeugt,
- mit Hilfe einer Fototechnik und unter Verwendung von Hartmasken werden der Graben 34 und die Isolationsgräben 46 bis 52 geätzt und anschließend mit Siliziumdioxid gefüllt. Das Siliziumdioxid wird dann planarisiert, beispielsweise mit Hilfe eines CMP-Prozesses (Chemical Mechanical Polishing), d.h. wie bei einem herkömmlichen STI-Prozess (Shallow Trench Insulation).
- Mit Hilfe einer weiteren Fototechnik werden Bereiche für die Gatebereiche 36 und 38 und für den Drainbereich 40 festgelegt. Anschließend wird das Siliziumdioxid in diesen Bereichen geätzt, wobei auf dem Silizium der n-Wanne 16 gestoppt wird.
- Beispielsweise mit Hilfe einer thermischen Oxidation wird ein dünnes Dielektrikum an Grabenwandbereichen und am freiliegenden Bodenbereich des Grabens 34 erzeugt.
- Mit Hilfe einer weiteren Fototechnik wird die Aussparung für den Drainbereich 78 ausgewählt. Anschließend wird die dünne Isolationsschicht am Boden der Aussparung für den Drainbereich 78 wieder entfernt, beispielsweise mit Hilfe eines reaktiven Ionenätzens oder nasschemisch.
- In einem folgenden Verfahrensschritt wird polykristallines Silizium in den Aussparungen für die Gatebereiche 36, 38 und für den Drainbereich 40 abgeschieden. Das polykristalline Silizium wird in-situ dotiert oder mit Hilfe einer nachträglichen Diffusion oder Implantation.
- Danach wird das stark n-dotierte polykristalline Silizium planarisiert, beispielsweise mit Hilfe eines CMP-Verfahrens. Gegebenenfalls lässt sich das polykristalline Silizium auch mit einer Fototechnik außerhalb des Grabens 34 entfernen.
- Mit Hilfe einer Fototechnik wird die Lage der Body-Bereiche 18, 20 festgelegt. Die Body-Bereiche werden dann p-dotiert (bzw. n-dotiert beim p-Kanal-DMOS), insbesondere mit Hilfe einer Diffusion oder Implantation. Anschließend oder vorher lassen sich auch n-Wannen für komplementäre Feldeffekttransistoren erzeugen,
- mit Hilfe einer Fototechnik werden die Anschlussbereiche 30, 32 festgelegt und gering n-dotiert, beispielsweise mit Hilfe einer einer Diffusion oder Implantation.
- Mit Hilfe einer weiteren Fototechnik werden die Sourcebereiche 22, 24 festgelegt und anschließend stark n-dotiert, bspw. mit einer Diffusion oder einer Implantation und
- mit Hilfe einer Fototechnik werden die Anschlussbereiche 26, 28 für die Body-Bereiche 18, 20 festgelegt und anschließend stark p-dotiert.

Die Epitaxieschicht 14, die vergrabene Schicht 70 und gegebenenfalls auch die vergrabenen Schichten werden vor der Durchführung der oben genannten Verfahrensschritte erzeugt, insbesondere dann, wenn ein BiCMOS-Verfahren durchgeführt wird, d.h. ein Verfahren, bei dem sowohl Bipolartransistoren als auch Feldeffekttransistoren erzeugt werden.

Bei der Herstellung des Transistors 110 werden im Wesentlichen die gleichen Verfahrensschritte ausgeführt. Jedoch wird die Aussparung für den Drainbereich zunächst nur bis zur gleichen Tiefe geätzt wie die Aussparungen für die Gatebereiche 136, 138, d.h. weniger als die halbe Grabentiefe des Grabens 134 tief. Danach wird die dünne Gate-Oxidschicht erzeugt. Erst danach wird die Aussparung für den Drainbereich 140 über den Grabenboden des Grabens 134 hinaus verlängert bis in die vergrabene Schicht 170 oder bis in die n-Wanne 116 hinein.

Bei der Herstellung des Transistors 210 werden ebenfalls ähnliche Verfahrensschritte durchgeführt. Jedoch wird nach dem Ätzen der flachen Isoliergräben 248, 250, und des flachen Teils des Grabens 234 eine Grabenätzung für tiefe Isoliergräben durchgeführt. Dabei werden die tiefen Grabenbereiche 302 und 304 des Grabens 234 erzeugt. Auch lassen sich in diesem Schritt an anderen Stellen des integrierten Schaltkreises tiefe Isoliergräben erzeugen, beispielsweise in Speicherzellenfeldern für sogenannte Trench-Kondensatoren.

Bei einem anderen Ausführungsbeispiel, das zum Verständnis des beanspruchten Verfahrens dient, werden an Stelle eines n-Kanal-DMOS-Transistors p-Kanal-DMOS-Transistoren mit Hilfe der gleichen Verfahrensschritte hergestellt, wobei jedoch entgegengesetzte Dotierungen verwendet werden.

Durch die gemeinsame Anordnung von Drain und Gate in einem Isoliergrabenbereich wird die effektiv benötigte Chipfläche reduziert. Dadurch verringert sich der spezifische Einschaltwiderstand RON. Außerdem erhöht sich der spezifische Sättigungsstrom ISAT. Über die Tiefe des Grabens bzw. über die Tiefe von Grabenbereichen lässt sich die Driftstrecke für größere Drainspannungen auf einfache Art und Weise einstellen.

Gemäß der erläuterten Ausführungsbeispiele, die zum Verständnis des beanspruchten Verfahrens dienen, hat jeder Graben einen Grabenrand, der den Graben umgibt. Der Grabenrand ist eine um den Graben herum laufende geschlossene Linie an derjenigen Oberfläche der Epitaxieschicht 14 bzw. des Substrates 14, an der auch der außerhalb des Grabens angeordnete Sourceanschlussbereich liegt.

## Patentansprüche

1. Verfahren zur Herstellung eines Feldeffekttransistors (10),
mit den ohne Beschränkung durch die angegebene Reihenfolge ausgeführten Verfahrensschritten:
Einbringen eines Grabens (34), der einen Grabenrand, Grabenwände und einen Grabenboden enthält, in einen mit einem ersten Dotiertyp dotierten Driftbereich (16) oder in einen Bereich, in dem ein mit einem ersten Dotiertyp dotierter Driftbereich (16) angeordnet wird,
Füllen des Grabens (34) mit einem Isoliermaterial (42, 44), Strukturieren des Isoliermaterials (42, 44), wobei eine Aussparung für einen Steuerbereich (36) des Feldeffekttransistors (10) und eine von dieser Aussparung durch Isoliermaterial (42, 44) getrennte Aussparung für einen mit dem Driftbereich (16) verbundenen Anschlussbereich (40) des Feldeffekttransistors (10) erzeugt werden,
Einbringen von elektrisch leitfähigem Material (36, 40) oder von in elektrisch leitfähiges Material (36, 40) umwandelbarem Material in die beiden Aussparungen,
Ausbilden eines außerhalb des Grabens (34) angeordneten mit einem ersten Dotiertyp dotierten Anschlussbereiches (22) vor oder nach dem Erzeugen des Grabens (34) und eines vom Steuerbereich durch ein Dielektrikum getrennten und mit einem zweiten Dotiertyp dotierten Bereiches (18) für die Ausbildung eines Inversionskanalgebietes (86) des Feldeffekttransistors (10) vor oder nach dem Erzeugen des Grabens (34).

2. Verfahren nach Anspruch 1, **dadurch gekennzeichnet, dass** das Verfahren zur Herstellung eines doppelt diffundierten Feldeffekttransistors (10) dient.

3. Verfahren nach Anspruch 1 oder 2, **gekennzeichnet durch** den Schritt:
Vertiefen des Grabens (234) in mindestens einem Teilbereich (302, 304) und Beibehalten der Grabentiefe in mindestens einem anderen Teilbereich,
wobei Grabenbereiche mit voneinander verschiedener Grabentiefe entstehen.

4. Verfahren nach einem der Ansprüche 1 bis 3, **gekennzeichnet durch** die Schritte:
Erzeugen der Aussparungen bis zum Grabenboden, wobei das Isoliermaterial (42, 44) in mindestens einem Grabenwandbereich der Aussparung für den Steuerbereich (36) entfernt wird,
Erzeugen einer dünnen Isolierschicht in der Aussparung für den Steuerbereich (36) und in der Aussparung für den Anschlussbereich (40),
Entfernen der dünnen Isolierschicht in der Aussparung für den Anschlussbereich (40) vor dem Einbringen des elektrisch leitfähigen Materials (36,40) in die Aussparungen,
oder **gekennzeichnet durch** die Schritte:
**Erzeugen** der Aussparungen mit Abstand zum Grabenboden, wobei das Isoliermaterial (242, 244) in mindestens einem Grabenwandbereich der Aussparung für den Steuerbereich (236) entfernt wird,
Erzeugen einer dünnen Isolierschicht in der Aussparung für den Steuerbereich (236),
Vertiefen der Aussparung für den Anschlussbereich (140).

5. Verfahren nach Anspruch 4, **dadurch gekennzeichnet, dass** das Vertiefen nach der Erzeugung der dünnen Isolierschicht erfolgt.

## Claims

1. Method for producing a field effect transistor (10),
comprising the following method steps that are implemented without any restriction by the order specified:
introducing a trench (34), containing a trench edge, trench walls and a trench bottom, into a drift region (16) doped with a first doping type or into a region in which a drift region (16) doped with a first doping type is arranged,
filling the trench (34) with an insulating material (42, 44),
patterning the insulating material (42, 44), and in the process producing a cutout for a control region (36) of the field effect transistor (10) and a cutout - which is isolated from the aforesaid cutout by insulating material (42, 44) - for a connection region (40) of the field effect transistor (10), said connection region being connected to the drift region (16),
introducing electrically conductive material (36, 40) or material that can be converted into electrically conductive material (36, 40) into the two cutouts,
forming a connection region (22) doped with a first doping type and arranged outside the trench (34) before or after the production of the trench (34), and a region (18) - which is isolated from the control region by a dielectric and is doped with a second doping type - for the formation of an inversion channel zone (86) of the field effect transistor (10) before or after the production of the trench (34).

2. Method according to Claim 1, **characterized in that** the method serves for producing a double diffused field effect transistor (10).

3. Method according to Claim 1 or 2, **characterized by** the step of:
deepening the trench (234) in at least one partial region (302, 304) and maintaining the trench depth in at least one other partial region,
wherein trench regions having mutually different trench depths arise.

4. Method according to any of Claims 1 to 3, **characterized by** the steps of:
producing the cutouts as far as the trench bottom, wherein the insulating material (42, 44) is removed in at least one trench wall region of the cutout for the control region (36),
producing a thin insulating layer in the cutout for the control region (36) and in the cutout for the connection region (40),
removing the thin insulating layer in the cutout for the connection region (40) prior to the introduction of the electrically conductive material (36, 40) into the cutouts,
or **characterized by** the steps of:
producing the cutouts at a distance from the trench bottom, wherein the insulating material (242, 244) is removed in at least one trench wall region of the cutout for the control region (236),
producing a thin insulating layer in the cutout for the control region (236),
deepening the cutout for the connection region (140).

5. Method according to Claim 4, **characterized in that** deepening is effected after the production of the thin insulating layer.

## Revendications

1. Procédé de fabrication d'un transistor (10) à effet de champ,
ayant les stades de procédé réalisés sans limitation dans l'ordre indiqué :
on ménage un sillon (34) qui comporte un bord, des parois et un fond dans une zone (16) de migration dopée par un premier type de dopage ou dans une zone dans laquelle est disposée une zone (16) de migration dopée par un premier type de dopage,
on remplit le sillon (34) d'un matériau (42.44) isolant,
on structure le matériau (42, 44) isolant en produisant un évidement pour une zone (36) de commande du transistor (10) à effet de champ et un évidement séparé de cet évidement par du matériau (42, 44) isolant pour une zone (40) de borne du transistor à effet de champ reliée à la zone (16) de migration,
on introduit du matériau (36, 40) conducteur de l'électricité ou du matériau pouvant être transformé en du matériau (36, 40) conducteur de l'électricité dans les deux évidements,
on forme une zone (22) de borne dopée par un premier type de dopage et disposée à l'extérieur du sillon (34) avant ou après la production du sillon (34) et une zone (18) séparée de la zone de commande par un diélectrique et dopée par un deuxième type de dopage pour la formation d'un domaine (86) de canal d'inversion du transistor (10) à effet de champ avant ou après la production du sillon (34).

2. Procédé suivant la revendication 1, **caractérisé en ce que** le procédé sert à la fabrication d'un transistor (10) à effet de champ à double diffusion.

3. Procédé suivant la revendication 1 ou 2, **caractérisé par** le stade :
on creuse le sillon (234) dans au moins une sous-zone (302, 304) et on conserve la profondeur du sillon dans au moins une autre sous-zone,
des zones de sillon ayant des profondeurs différentes l'une de l'autre étant créées.

4. Procédé suivant l'une des revendications 1 à 3, **caractérisé par** les stades :
on produit les évidements jusqu'au fond du sillon, le matériau (42, 44) étant éliminé dans au moins une partie de paroi du sillon de l'évidement pour la zone (36) de commande,
on produit une mince couche isolante dans l'évidement pour la zone (36) de commande et dans l'évidement pour la zone (40) de borne,
on élimine la mince couche isolante dans l'évidement pour la zone (40) de borne avant l'introduction du matériau (36, 40) conducteur de l'électricité dans les évidements,
ou **caractérisé par** les stades :
on produit les évidements à distance du fond du sillon, le matériau (242, 244) isolant étant éliminé dans au moins une zone de paroi du sillon de l'évidement pour la zone (236) de commande,
on produit une mince couche isolante dans l'évidement pour la zone (236) de commande,
on creuse l'évidement pour la zone (242) de borne.

5. Procédé suivant la revendication 4, **caractérisé en ce que** l'on effectue le creusement après la production de la mince couche isolante.
